(19) Europäisches Patentamt
European Patent Office
Office européen des brevets

(11) EP 3 432 377 A1

(12) **EUROPEAN PATENT APPLICATION**
published in accordance with Art. 153(4) EPC

(43) Date of publication:
**23.01.2019 Bulletin 2019/04**

(21) Application number: **17766609.6**

(22) Date of filing: **13.03.2017**

(51) Int Cl.:
***H01L 51/46*** *(2006.01)* ***C08K 5/06*** *(2006.01)*
***C08L 25/02*** *(2006.01)* ***C08L 65/00*** *(2006.01)*
***C08L 71/02*** *(2006.01)*

(86) International application number:
**PCT/JP2017/009950**

(87) International publication number:
**WO 2017/159609 (21.09.2017 Gazette 2017/38)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **18.03.2016 JP 2016055186**
**18.03.2016 JP 2016055187**

(71) Applicant: **Toray Industries, Inc.**
**Tokyo 103-8666 (JP)**

(72) Inventors:
- **ASAKA, Keisuke**
  **Otsu-shi**
  **Shiga 520-8558 (JP)**
- **YAMAMOTO, Shuhei**
  **Otsu-shi**
  **Shiga 520-8558 (JP)**
- **KITAZAWA, Daisuke**
  **Otsu-shi**
  **Shiga 520-8558 (JP)**

(74) Representative: **Kador & Partner PartG mbB**
**Corneliusstraße 15**
**80469 München (DE)**

(54) **PHOTOVOLTAIC ELEMENT**

(57) The objective of the present invention is to provide a photovoltaic element having excellent photoelectric conversion efficiency. The photovoltaic element of the present invention for achieving the objective has the following configuration. That is, the photovoltaic element has at least a negative electrode, a photoelectric conversion layer, a hole extraction layer, and a positive electrode in this order, wherein the hole extraction layer contains a hole transporting material and a compound represented by general formula (1) or (2) below. (In formula (1), $R^1$ represents an alkyl group having 8-14 carbon atoms or an alkanoyl group having 8-14 carbon atoms, and n represents a natural number of 1-9. In formula (2), $R^2$ represents an alkenyl group, and m represents a natural number.)

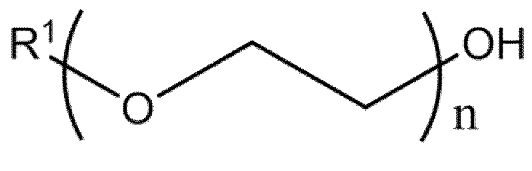
(1)

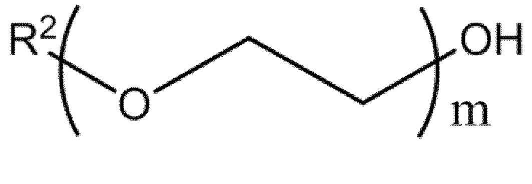
(2)

EP 3 432 377 A1

[Fig 1]

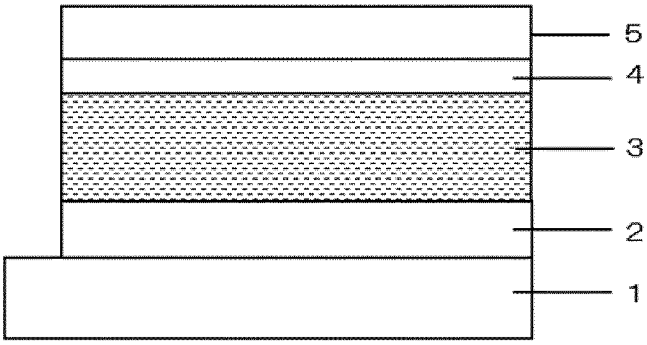

## Description

### TECHNICAL FIELD

The present invention relates to a photovoltaic element.

### BACKGROUND ART

Solar cells are attracting attention as a promising and environmentally friendly energy source to address the recent increasingly severe energy problems. Currently, inorganic materials such as monocrystal silicon, polycrystal silicon, amorphous silicon, and compound semiconductors are used as a semiconductor material of a photovoltaic element of solar cells. Solar cells manufactured using inorganic semiconductors, however, are higher in cost than power generation methods such as thermal power generation, and thus have not been widely spread to ordinary households. The main reason for the high cost lies in the process of forming a semiconductor thin film under vacuum and high temperature. Under such circumstances, as a semiconductor material whose manufacturing process is expected to be simplified, organic semiconductors such as conjugated polymers and organic crystals as well as organic solar cells based on organic dyes have been studied. The manufacturing process of such organic solar cells can be greatly simplified since it is possible to produce a semiconductor material by a coating method.

Organic solar cells based on a conjugated polymer or the like have not yet been put to practical use because of their low photoelectric conversion efficiency and thermal stability as compared with conventional solar cells based on an inorganic semiconductor. In order to put organic solar cells to practical use, it is essential to achieve high photoelectric conversion efficiency and thermal stability for sustaining the high photoelectric conversion efficiency for a long time, that is, high durability.

One method for improving the photoelectric conversion efficiency and durability of an organic solar cell is a method of providing a hole extraction layer between a power generation layer and an anode. As a material of the hole extraction layer, a conductive polymer such as PEDOT:PSS is known.

For example, Patent Document 1 describes that a hole extraction layer is formed by forming a film from a hole extraction layer coating liquid containing PEDOT:PSS and an acetylene glycol compound by a spin coating method.

### PRIOR ART DOCUMENT

### PATENT DOCUMENT

Patent Document 1: Japanese Patent Laid-open Publication No. 2014-27174

### SUMMARY OF THE INVENTION

### PROBLEMS TO BE SOLVED BY THE INVENTION

According to the studies by the present inventors, however, when the hole extraction layer coating liquid was applied to the photoelectric conversion layer by the method of Patent Document 1, excellent photoelectric conversion efficiency was not obtained. An object of the present invention is to provide a photovoltaic element excellent in photoelectric conversion efficiency.

### SOLUTIONS TO THE PROBLEMS

As a result of intensive studies made by the present inventors, they surmised that the reason why excellent photoelectric conversion efficiency was not obtained was the poor film forming properties caused by the low affinity between the photoelectric conversion layer made from an organic semiconductor and the hole extraction layer. The present inventors paid attention to the fact that the electron-donating organic material for forming the photoelectric conversion layer has a hydrophobic alkyl group in the side chain, and thought that incorporation of a surfactant similarly having a hydrophobic alkyl group into the hole extraction layer improves the affinity between the photoelectric conversion layer and the hole extraction layer and makes the hole extraction layer flat. Then, they mixed various compounds capable of functioning as a surfactant in the material of the hole extraction layer, and found that incorporation of the compound represented by the following general formula (1) or (2) into the hole extraction layer makes it possible to form a flat hole extraction layer on the photoelectric conversion layer and to provide a photovoltaic element excellent in photoelectric conversion efficiency:

[Chemical Formula 1]

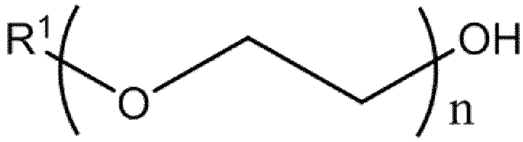

(1)

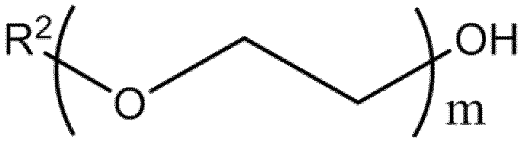

(2)

wherein, in the formula (1), $R^1$ represents an alkyl group having 8 to 14 carbon atoms or an alkanoyl group having 8 to 14 carbon atoms, and n represents a natural number of 1 to 9; and in the formula (2), $R^2$ represents an alkenyl group, and m represents a natural number.

That is, the present invention provides a photovoltaic element including at least a cathode, a photoelectric conversion layer, a hole extraction layer, and an anode in this order, the hole extraction layer containing a hole transporting material and a compound represented by the general formula (1) or (2).

EFFECTS OF THE INVENTION

According to the present invention, it is possible to provide a photovoltaic element that is good in the film forming properties of the hole extraction layer and is excellent in photoelectric conversion efficiency.

BRIEF DESCRIPTION OF THE DRAWING

Fig. 1 is a cross-sectional view showing one aspect of the photovoltaic element of the present invention.

EMBODIMENTS OF THE INVENTION

The photovoltaic element of the present invention is a photovoltaic element including at least a cathode, a photoelectric conversion layer, a hole extraction layer, and an anode in this order, the hole extraction layer containing a hole transporting material and a compound represented by the following general formula (1) or (2):

[Chemical Formula 2]

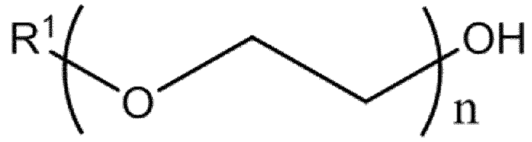

(1)

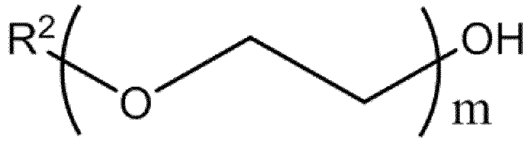

(2)

wherein, in the formula (1), $R^1$ represents an alkyl group having 8 to 14 carbon atoms or an alkanoyl group having 8 to 14 carbon atoms, and n represents a natural number of 1 to 9; and in the formula (2), $R^2$ represents an alkenyl group, and m represents a natural number.

Hereinafter, the photovoltaic element of the present invention will be described. Fig. 1 is a cross-sectional view showing one aspect of the photovoltaic element of the present invention. The photovoltaic element in Fig. 1 has, on a substrate 1, a cathode 2, a photoelectric conversion layer 3, a hole extraction layer 4, and an anode 5 in this order. Incidentally, "have in this order" means that another layer may be provided between the layers as in the aspect in which a charge recombination layer is provided as will be described later as long as the layers are present in this order.

The substrate is a substrate on which an electrode material and an organic semiconductor layer can be stacked depending on the kind and application of the photoelectric conversion material. It is possible to use a film or a plate produced by any method from inorganic materials such as alkali-free glass, quartz glass, aluminum, iron, copper, and alloys including stainless steel, and organic materials such as polyesters, polycarbonates, polyolefins, polyamides, polyimides, polyphenylene sulfide, polyparaxylene polymethyl methacrylate, epoxy resins, and fluororesins.

In the case where the photovoltaic element is used with light being incident on the substrate side, it is preferable that each of the above-mentioned substrates have light permeability.

Examples of preferably used materials of the electrodes (cathode and anode) include metals such as gold, platinum, silver, copper, iron, zinc, tin, aluminum, indium, chromium, nickel, cobalt, scandium, vanadium, yttrium, cerium, samarium, europium, terbium, ytterbium, molybdenum, tungsten, and titanium, as well as metal oxides, composite metal oxides (such as indium tin oxide (ITO), indium zinc oxide (IZO), aluminum zinc oxide (AZO), gallium zinc oxide (GZO), and fluorine-doped tin oxide (FTO)), alkali metals, and alkaline earth metals (lithium, magnesium, sodium, potassium, calcium, strontium, and barium). Further, electrodes made from an alloy of the above-mentioned metals or a laminate of the above-mentioned metals are also preferably used. In addition, electrodes containing graphite, graphite intercalation compounds, carbon nanotubes, graphene, polyaniline and derivatives thereof, and polythiophene and derivatives thereof are also preferably used. Further, the above-mentioned electrode materials may be a mixed layer made from two or more kinds of materials. In addition, the electrode may have a laminated structure in which two or more layers made from different materials are stacked.

The conductive material used in the cathode is preferably capable of forming an ohmic contact with the photoelectric conversion layer. Further, in the case where an electron extraction layer described later is used, it is preferable that the conductive material used in the cathode be capable of forming an ohmic contact with the electron extraction layer. Further, the conductive material used in the anode is preferably capable of forming an ohmic contact with the hole extraction layer.

The cathode or the anode of the photovoltaic element preferably has light permeability. It suffices that at least one of the cathode and the anode has light permeability, but both of them may have light permeability. Herein, having light permeability means that an electrode is permeable to light to the extent that incident light reaches the photoelectric conversion layer and the photovoltaic element generates electromotive force. That is, when an electrode has a light transmittance value exceeding 0%, the electrode is said to have light permeability. Such a light-permeable electrode preferably has a light transmittance of 60 to 100% in the whole wavelength region of 400 nm or more and 900 nm or less. The thickness of the light-permeable electrode may be any thickness as long as sufficient electric conductivity is obtained, and is preferably 20 nm to 300 nm although it varies depending on the material. Note that a light-impermeable electrode has only to have electric conductivity, and the thickness thereof is also not particularly limited.

In the photovoltaic element of the present invention, an electron extraction layer may be provided between the photoelectric conversion layer and the cathode. The electron extraction layer can form an interfacial state suitable for carrier extraction, and has an effect of preventing a short circuit between the electrodes. Examples of a material for forming the electron extraction layer include organic semiconductors having an electron transporting ability, such as 1,4,5,8-naphthalenetetracarboxylic dianhydride, 3,4,9,10-perylenetetracarboxylic dianhydride, N,N'-dioctyl-3,4,9,10-naphthyltetracarboxydiimide, oxazole derivatives (such as 2-(4-biphenylyl)-5-(4-t-butylphenyl)-1,3,4-oxadiazole and 2,5-di(1-naphthyl)-1,3,4-oxadiazole), triazole derivatives (such as 3-(4-biphenylyl)-4-phenyl-5-(4-t-butylphenyl)-1,2,4-triazole), phenanthroline derivatives, fullerene derivatives, carbon nanotubes, and a derivative obtained by introducing a cyano group into a poly-p-phenylene vinylene polymer (CN-PPV). It is also possible to preferably use, as the material of the electron extraction layer, inorganic materials including metal oxides such as titanium oxide ($TiO_x$) such as $TiO_2$, zinc oxide ($ZnO_x$) such as ZnO, silicon oxide ($SiO_x$) such as $SiO_2$, tin oxide ($SnO_x$) such as $SnO_2$, indium oxide ($InO_x$) such as $In_2O_3$, molybdenum oxide ($MoO_x$) such as $MoO_3$, tungsten oxide ($WO_x$) such as $WO_3$, tantalum oxide ($TaO_x$) such as $Ta_2O_3$, barium titanate ($BaTi_xO_y$) such as $BaTiO_3$, barium zirconate ($BaZr_xO_y$) such as $BaZrO_3$, zirconium oxide ($ZrO_x$) such as $ZrO_2$, hafnium oxide ($HfO_x$) such as $HfO_2$, aluminum oxide ($AlO_x$) such as $Al_2O_3$, yttrium oxide ($YO_x$) such as $Y_2O_3$, and zirconium silicate ($ZrSi_xO_y$) such as $ZrSiO_4$, nitrides such as silicon nitride ($SiN_x$) such as $Si_3N_4$, and semiconductors such as cadmium sulfide ($CdS_x$) such as CdS, zinc selenide ($ZnSe_x$) such as ZnSe, zinc sulfide ($ZnS_x$) such as ZnS, and cadmium telluride ($CdTe_x$) such as CdTe. Among them, inorganic oxides are preferable, and n-type semiconductors are more preferable from the viewpoint of electron extraction efficiency and electron transfer. Further, from the viewpoint of n-type semiconductivity, the inorganic oxide preferably contains at least one of zinc, titanium, tin, and indium, and more preferably contains at least zinc or titanium. In addition, the electron extraction layer may contain substances other than the above-mentioned inorganic compounds to the extent that electron extraction and electron transfer are not inhibited. Therefore, in the case where a method of forming an inorganic compound layer by application and heating of a precursor solution of a metal salt or a metal alkoxide, or a method of forming an inorganic compound layer by application of a nanoparticle dispersion liquid to a substrate is used in forming the inorganic compound layer, it is allowable depending on the heating temperature and time and the synthesis conditions of the nanoparticles that the reaction does not proceed perfectly and the reactants are partially hydrolyzed or partially condensed to turn into an intermediate product, or a mixture of a precursor and an intermediate product, a final product, or the like. The electron extraction layer has only to have a thickness sufficient for electron extraction, and too thick an electron extraction layer may be reduced in the electron extraction efficiency. Since the thickness of the electron extraction layer is required to be appropriately set to an optimal film thickness depending on the desired photoelectric conversion efficiency of the photovoltaic element, it cannot be unconditionally determined. However, in general, the thickness is preferably 0.1 nm to 1000 nm, more preferably 0.5 nm to 100 nm, still more preferably 5 nm to 50 nm.

Then, the photoelectric conversion layer will be described. The photoelectric conversion layer is present between the cathode and the hole extraction layer, and preferably contains at least an electron-donating organic semiconductor and an electron-accepting organic semiconductor described later. Examples of the photoelectric conversion layer include a layer made from a mixture of an electron-donating organic semiconductor and an electron-accepting organic semiconductor, a laminated structure of a layer made from an electron-donating organic semiconductor and a layer made from an electron-accepting organic semiconductor, and a laminated structure of a layer made from an electron-donating organic semiconductor, a layer made from an electron-accepting organic semiconductor, and a layer made from a mixture of these semiconductors provided between the two layers. The photoelectric conversion layer may contain two or more kinds of electron-donating organic semiconductors or electron-accepting organic semiconductors. In addition, it is preferable that the electron-donating organic semiconductor and the electron-accepting organic semiconductor form a mixed layer.

The content ratio between the electron-donating organic semiconductor and the electron-accepting organic semiconductor in the photoelectric conversion layer is not particularly limited, but the weight fraction of electron-donating organic semiconductor : electron-accepting organic semiconductor is preferably in the range of 1 to 99 : 99 to 1, more preferably in the range of 10 to 90 : 90 to 10, still more preferably in the range of 20 to 60 : 80 to 40.

The thickness of the photoelectric conversion layer is required to be a thickness that is sufficient for the electron-donating organic semiconductor and the electron-accepting organic semiconductor to generate photovoltaic power by light absorption. Although the preferable thickness depends on the material, in general, the thickness is preferably 10 nm to 1000 nm, more preferably 50 nm to 500 nm. Further, the photoelectric conversion layer may contain other components such as a surfactant, a binder resin, and a filler.

The electron-donating organic semiconductor is not particularly limited as long as it is an organic compound showing p-type semiconductor characteristics. Examples of the electron-donating organic semiconductor include: conjugated polymers such as a polythiophene polymer, a 2,1,3-benzothiadiazole-thiophene copolymer, a quinoxaline-thiophene copolymer, a thiophene-benzodithiophene copolymer, a poly-p-phenylene vinylene polymer, a poly-p-phenylene polymer, a polyfluorene polymer, a polypyrrole polymer, a polyaniline polymer, a polyacetylene polymer, and a polythienylenevinylene polymer; and low-molecular organic compounds such as phthalocyanine derivatives including $H_2$

phthalocyanine ($H_2Pc$), copper phthalocyanine (CuPc), and zinc phthalocyanine (ZnPc), porphyrin derivatives, triarylamine derivatives including N,N'-diphenyl-N,N'-di(3-methylphenyl)-4,4'-diphenyl-1,1'-diamine (TPD) and N,N'-dinaphthyl-N,N'-diphenyl-4,4'-diphenyl-1,1'-diamine (NPD), carbazole derivatives including 4,4'-di(carbazol-9-yl)biphenyl (CBP), and oligothiophene derivatives (such as terthiophene, quaterthiophene, sexithiophene, and octithiophene). Two or more kinds of these may be used.

The polythiophene polymer refers to a conjugated polymer having a thiophene skeleton in the main chain, and includes those having a side chain. Specific examples thereof include poly-3-alkylthiophenes such as poly-3-methylthiophene, poly-3-butylthiophene, poly-3-hexylthiophene, poly-3-octylthiophene, and poly-3-decylthiophene, poly-3-alkoxythiophenes such as poly-3-methoxythiophene, poly-3-ethoxythiophene, and poly-3-dodecyloxythiophene, and poly-3-alkoxy-4-alkylthiophenes such as poly-3-methoxy-4-methylthiophene and poly-3-dodecyloxy-4-methylthiophene.

The 2,1,3-benzothiadiazole-thiophene copolymer refers to a conjugated copolymer having a thiophene skeleton and a 2,1,3-benzothiadiazole skeleton in the main chain. Specific examples of the 2,1,3-benzothiadiazole-thiophene copolymer include the following structures. In the following formulae, n represents an integer of 1 to 1000.

[Chemical Formula 3]

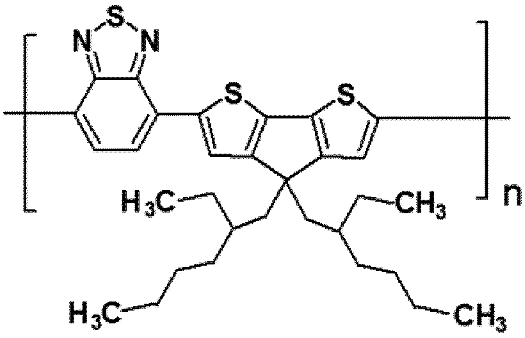

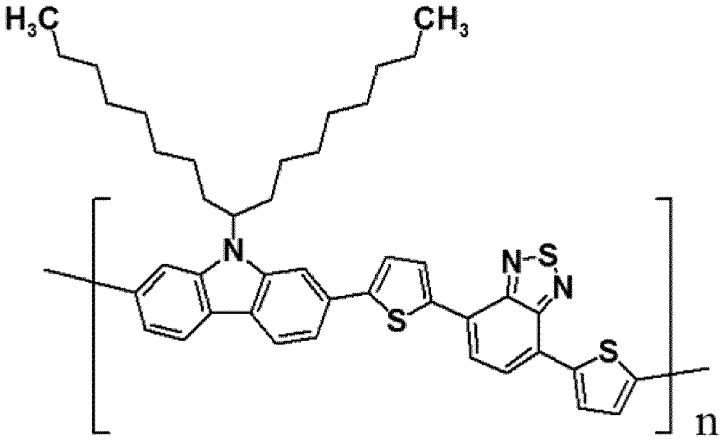

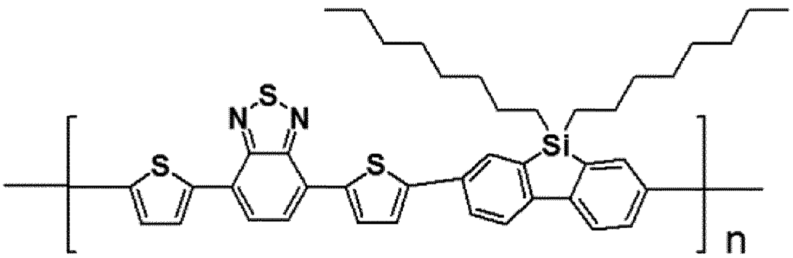

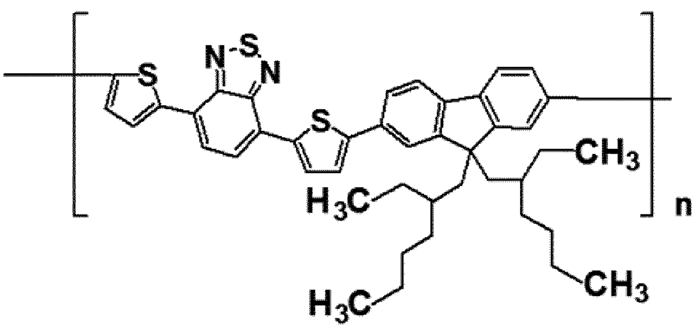

The quinoxaline-thiophene copolymer refers to a conjugated copolymer having a thiophene skeleton and a quinoxaline skeleton in the main chain. Specific examples of the quinoxaline-thiophene copolymer include the following structures. In the following formulae, n represents an integer of 1 to 1000.

[Chemical Formula 4]

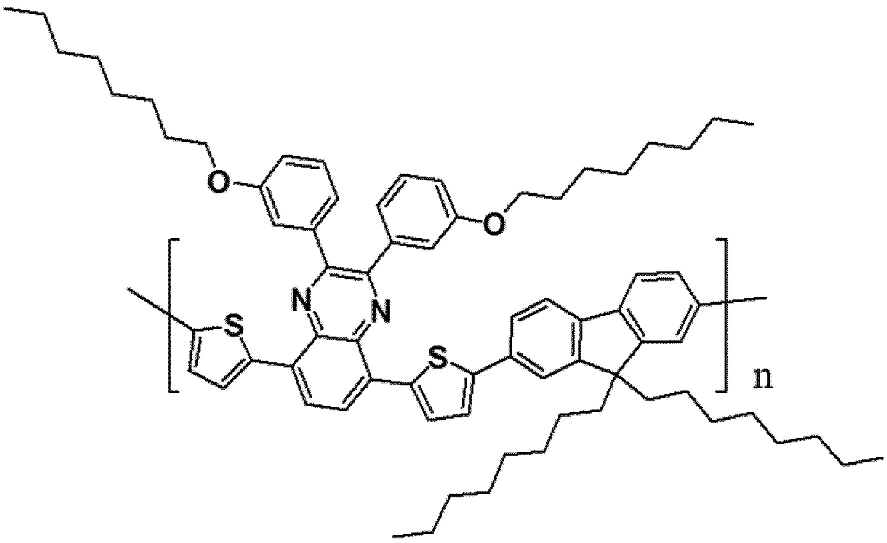

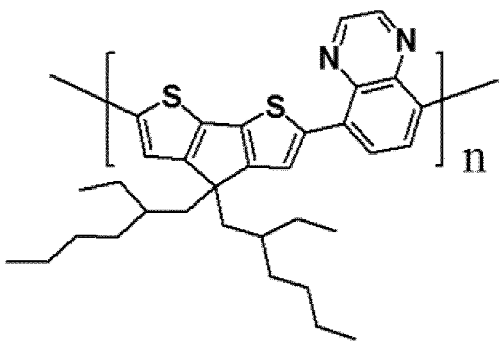

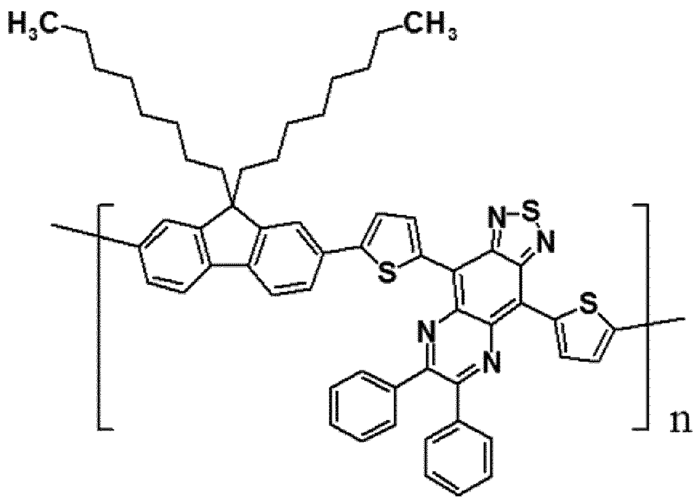

The thiophene-benzodithiophene polymer refers to a conjugated copolymer having a thiophene skeleton and a benzodithiophene skeleton in the main chain. Specific examples of the thiophene-benzodithiophene copolymer include the following structures. In the following formulae, n represents an integer of 1 to 1000.

[Chemical Formula 5]

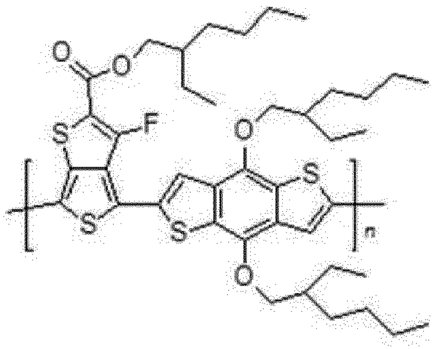

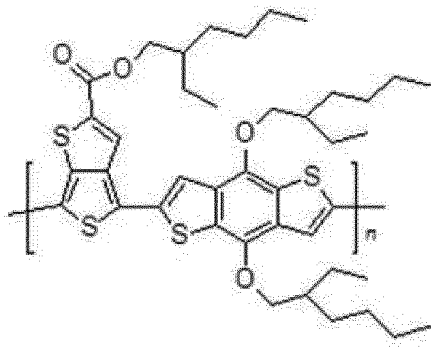

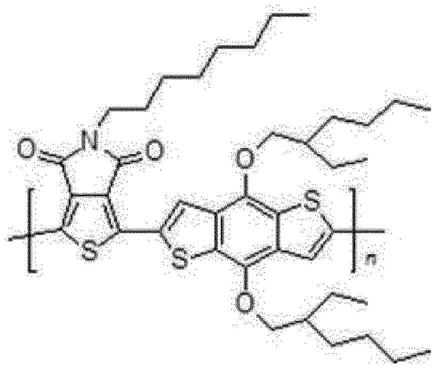

The poly-p-phenylene vinylene polymer refers to a conjugated polymer having a p-phenylene vinylene skeleton in the main chain, and includes those having a side chain. Specific examples thereof include poly[2-methoxy-5-(2-ethylhexyloxy)-1,4-phenylenevinylene] and poly[2-methoxy-5-(3',7'-dimethyloctyloxy)-1,4-phenylenevinylene].

Among the electron-donating organic semiconductors mentioned above, the conjugated polymer having a skeleton represented by any one of the following general formulae (3) to (5) is repeatedly reported to improve the photovoltaic power characteristics when 1,8-diiodooctane is used as an additive (see, for example, Japanese Patent No. 05829734, "Advanced Materials", 2010, vol. 22, pp. E135-E138, "Journal of the American Chemistry, 2010, vol. 132, pp. 7595-7597", "Macromolecules, 2012, vol. 45, pp. 6923-6929", and "Advanced Materials", 2011, vol. 23, pp.

3315-3319). Such a conjugated polymer is preferably contained as the electron-donating organic semiconductor of the composition of the present invention.

[Chemical Formula 6]

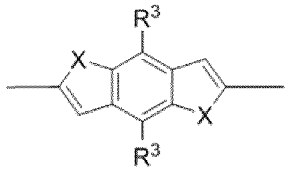
(3)
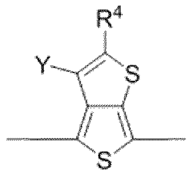
(4)
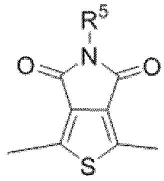
(5)

(In the general formula (3), $R^3$s may be the same or different, and each represent an alkyl group, an alkoxy group, an optionally substituted heteroaryl group, an optionally substituted aryl group, or a thioalkoxy group. Xs may be the same or different, and each represent a sulfur, selenium, or oxygen atom.)

(In the general formula (4), $R^4$ represents an alkoxycarbonyl group or an alkanoyl group. Y represents a hydrogen atom or a halogen.)

(In the general formula (5), $R^5$ represents an alkyl group, an optionally substituted heteroaryl group, or an optionally substituted aryl group.)

Among conjugated polymers having the above-mentioned skeleton structures, a conjugated polymer represented by the following general formula (6), which has a wide light absorption wavelength region and a deep HOMO level and thus can provide good photovoltaic power characteristics, is more preferable as the electron-donating organic semiconductor of the composition of the present invention.

[Chemical Formula 7]

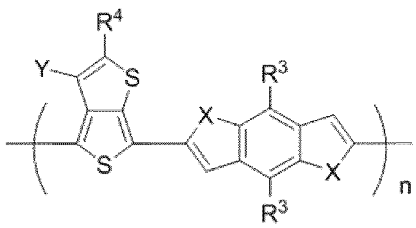
(6)

(In the general formula (6), $R^3$, $R^4$, X, and Y are the same as those in the general formulae (3) and (4).)

The electron-accepting organic semiconductor is not particularly limited as long as it is an organic compound showing n-type semiconductor characteristics. Examples thereof include 1,4,5,8-naphthalenetetracarboxylic dianhydride, 3,4,9,10-perylenetetracarboxylic dianhydride, N,N'-dioctyl-3,4,9,10-naphthyltetracarboxydiimide, oxazole derivatives (such as 2-(4-biphenylyl)-5-(4-t-butylphenyl)-1,3,4-oxadiazole and 2,5-di(1-naphthyl)-1,3,4-oxadiazole), triazole derivatives (such as 3-(4-biphenylyl)-4-phenyl-5-(4-t-butylphenyl)-1,2,4-triazole), phenanthroline derivatives, fullerenes, fullerene derivatives, carbon nanotubes, and a derivative obtained by introducing a cyano group into a poly-p-phenylene vinylene polymer (CN-PPV). Two or more kinds of these may be used. A fullerene or a fullerene derivative is preferably used since they are n-type semiconductors that are stable and have high carrier mobility. That is, in the photovoltaic element of the present invention, it is preferable that the photoelectric conversion layer contain an electron-donating organic semiconductor and a fullerene or a fullerene derivative.

Specific examples of the fullerene or fullerene derivative include unsubstituted derivatives such as $C_{60}$, $C_{70}$, $C_{76}$, $C_{78}$, $C_{82}$, $C_{84}$, $C_{90}$, and $C_{94}$ fullerenes, and substituted derivatives such as [6,6]-phenyl C61 butyric acid methyl ester ([6,6]-C61-PCBM or [60]PCBM), [5,6]-phenyl C61 butyric acid methyl ester, [6,6]-phenyl C61 butyric acid hexyl ester, [6,6]-phenyl C61 butyric acid dodecyl ester, and phenyl C71 butyric acid methyl ester ([70]PCBM). Among them, [70]PCBM is more preferable.

Then, the hole extraction layer will be described. The hole extraction layer in the present invention contains a compound represented by the following general formula (1) or (2) and a hole transporting material:

[Chemical Formula 8]

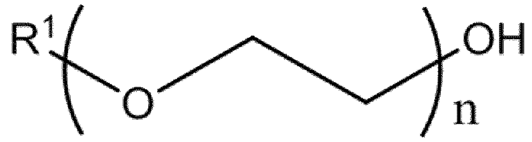

(1)

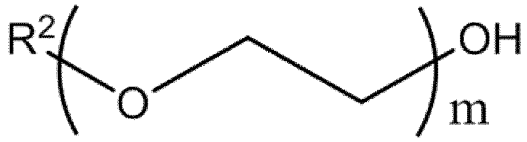

(2)

wherein, in the formula (1), $R^1$ represents an alkyl group having 8 to 14 carbon atoms or an alkanoyl group having 8 to 14 carbon atoms, and n represents a natural number of 1 to 9; and in the formula (2), $R^2$ represents an alkenyl group, and m represents a natural number. The main chain structure of the alkyl group, alkanoyl group, and alkenyl group in the above-mentioned formulae may be either linear, branched, or cyclic, and is not particularly limited, but it is preferably linear.

Use of the compound represented by the general formula (1) or (2) makes it possible to improve the affinity between the photoelectric conversion layer and the hole extraction layer and to form a flat hole extraction layer at the time of forming the hole extraction layer on the photoelectric conversion layer.

From the viewpoint of affinity to and solubility in general coating solvents, it is preferable that the photovoltaic element of the present invention contain the compound represented by the general formula (1) wherein $R^1$ is an alkyl group having 10 to 13 carbon atoms or an alkanoyl group having 10 to 13 carbon atoms. $R^1$ is more preferably an alkyl group having 12 carbon atoms or an alkanoyl group having 12 carbon atoms, and is still more preferably a dodecyl group. From the viewpoint of affinity to and solubility in general coating solvents, it is preferable that the photovoltaic element of the present invention contain the compound represented by the general formula (1) wherein n is a natural number of 3 to 6. Any combination of $R^1$ and n is employable. Above all, in the general formula (1), it is more preferable that $R^1$ be an alkyl group having 12 carbon atoms or an alkanoyl group having 12 carbon atoms, and n be a natural number of 1 to 9, it is still more preferable that $R^1$ be a dodecyl group and n be a natural number of 1 to 9, and it is particularly preferable that $R^1$ be a dodecyl group and n be a natural number of 3 to 6.

Specific examples of such compounds include polyoxyethylene alkyl ethers (wherein n is 1 to 9) such as polyoxyethylene (4) lauryl ether and polyoxyethylene (5) tridecyl ether, and polyethylene glycol monolaurates (wherein n is 1 to 9). Among them, compounds in which the hydrophobic group (the group represented by $R^1$ in the general formula (1)) has 12 carbon atoms, such as polyoxyethylene lauryl ethers and polyethylene glycol monolaurates are preferable. The hydrophobic group (the group represented by $R^1$ in the general formula (1)) is particularly preferably a dodecyl group. Among them, polyoxyethylene (3) lauryl ether, polyoxyethylene (4) lauryl ether, polyoxyethylene (5) lauryl ether, and polyoxyethylene (6) lauryl ether in which n is 3 to 6 are preferable. In the present invention, the numbers in parentheses in the representations such as "polyoxyethylene (4) lauryl ether" represent the repeating numbers of oxyethylene units.

In the general formula (2), from the viewpoint of affinity to and solubility in general coating solvents, the number of carbon atoms of the group represented by $R^2$ is preferably 16 to 20, more preferably 18. The group represented by $R^2$ is particularly preferably an oleyl group. Further, in the general formula (2), m is preferably a natural number of 5 to 20, particularly preferably a natural number of 7 to 13. Any combination of $R^2$ and m is employable. In the photovoltaic element of the present invention, it is preferable that the photovoltaic element contain the compound represented by the general formula (2) wherein $R^2$ is an oleyl group, and m is a natural number of 5 to 20. It is more preferable that $R^2$ be an oleyl group and m be a natural number of 7 to 13.

Specific examples of the compound represented by the general formula (2) include polyoxyethylene (4) oleyl ether, polyoxyethylene (5) oleyl ether, polyoxyethylene (7) oleyl ether, polyoxyethylene (10) oleyl ether, polyoxyethylene (13) oleyl ether, and polyoxyethylene (20) oleyl ether. Among them, polyoxyethylene (10) oleyl ether and polyoxyethylene (13) oleyl ether are particularly preferable. These compounds represented by the general formula (1) or (2) may be used singly or as a mixture of two or more kinds.

The concentration of the compound represented by the general formula (1) or (2) in the hole extraction layer

is not particularly limited as long as the function of the hole extraction layer is not impaired. The concentration is preferably in the range of 0.01 to 50% by weight, more preferably in the range of 0.1 to 40% by weight. The thickness of the hole extraction layer is preferably 5 nm to 600 nm, more preferably 10 nm to 200 nm.

In the present invention, the hole extraction layer contains a hole transporting material. Examples of the hole transporting material include: conductive polymers such as a polythiophene polymer, a poly-p-phenylene vinylene polymer, a polyfluorene polymer, a polypyrrole polymer, a polyaniline polymer, a polyfuran polymer, a polypyridine polymer, and a polycarbazole polymer; low-molecular organic compounds showing p-type semiconductor characteristics, such as phthalocyanine derivatives (including $H_2Pc$, CuPc, and ZnPc), porphyrin derivatives, and acene compounds (including tetracene and pentacene); carbon compounds such as carbon nanotubes, graphene, and graphene oxide; and inorganic compounds such as molybdenum oxide ($MoO_x$) such as $MoO_3$, tungsten oxide ($WO_x$) such as $WO_3$, nickel oxide ($NiO_x$) such as NiO, vanadium oxide ($VO_x$) such as $V_2O_5$, zirconium oxide ($ZrO_x$) such as $ZrO_2$, copper oxide ($CuO_x$) such as $CU_2O$, copper iodide, ruthenium oxide ($RuO_x$) such as $RuO_4$, and ruthenium oxide ($ReO_x$) such as $Re_2O_7$. Above all, the hole transporting material in the photovoltaic element of the present invention preferably contains a conductive polymer from the viewpoint of electric conductivity and stability. Further, from the above-mentioned viewpoint, it is more preferable that the photovoltaic element of the present invention contain, as the conductive polymer, polyethylene dioxythiophene to which polystyrene sulfonate (PSS) is added (PEDOT:PSS). The hole transporting material may be a single compound or a mixture of two or more kinds of compounds. Further, the hole transporting layer may have a laminated structure in which two or more layers made from different hole transporting materials are stacked.

In the photovoltaic element of the present invention, two or more photoelectric conversion layers may be stacked (in tandem) via one or more charge recombination layers to form a series junction. For example, the photovoltaic element may have a laminated structure of substrate/cathode/first photoelectric conversion layer/first hole extraction layer/charge recombination layer/second photoelectric conversion layer/second hole extraction layer/anode. In this case, the charge recombination layer is thought to serve also as the cathode and the anode to the adjacent photoelectric conversion layer. Such a laminated structure can improve the open circuit voltage. Note that the above-mentioned electron extraction layer may be provided between the cathode and the first photoelectric conversion layer and between the charge recombination layer and the second photoelectric conversion layer.

The charge recombination layer used herein needs to have light permeability so that a plurality of photoelectric conversion layers can absorb light. In addition, since the charge recombination layer has only to be designed so as to allow sufficient recombination of holes and electrons, the charge recombination layer does not necessarily need to be a film, and may be, for example, a metal cluster uniformly formed on the photoelectric conversion layer. Therefore, the one used as the charge recombination layer may be, for example, a very thin metal film or metal cluster (including alloys) having a thickness of approximately several angstroms to several tens of angstroms and having light permeability, which is made from the above-mentioned materials such as gold, platinum, chromium, nickel, lithium, magnesium, calcium, tin, silver, and aluminum; a metal oxide film or cluster having high light permeability, which is made from ITO, IZO, AZO, GZO, FTO, titanium oxide, molybdenum oxide or the like; a conductive organic material film, such as PEDOT to which PSS is added; or a composite of these. For example, vapor-depositing silver on a crystal oscillator film thickness monitor by a vacuum deposition method so as to have a thickness of several angstroms to 1 nm can form a uniform silver cluster. In addition, when a titanium oxide film is to be formed, the sol-gel method described in Advanced Materials, 2006, vol. 18, pp. 572-576 may be used. If the charge recombination layer is made from a composite metal oxide such as ITO or IZO, the layer may be formed by a sputtering method. An appropriate method for formation and an appropriate kind of the charge recombination layer may be selected from those described above in consideration of the property of not destroying the photoelectric conversion layer in the formation of the charge recombination layer and the method for forming the photoelectric conversion layer to be stacked subsequently.

Then, an example of a method for producing the photovoltaic element of the present invention will be described. An electrode (cathode) is formed on a substrate by a sputtering method or the like. In the case where an electron transporting layer is provided between the cathode and the photoelectric conversion layer, a desired electron extraction layer may be formed by a method of applying and heating a precursor solution of a metal salt or a metal alkoxide, a method of applying a nanoparticle dispersion liquid to the substrate to form a layer, or a method of applying and drying an electron-transporting organic semiconductor solution. The coating method employed may be any method such as spin coating, blade coating, slit die coating, screen printing coating, bar coater coating, coating with a mold, a printing and transfer method, an immersion and withdrawal method, an ink jet method, and a spray method. The coating method may be selected according to the coating film characteristics to be obtained, such as coating film thickness control and orientation control.

Then, a photovoltaic element material containing an electron-donating organic semiconductor material and an electron-accepting organic material is dissolved in a solvent to form a solution, and the solution is applied to the cathode or the electron transporting layer to form a photoelectric conversion layer. The solvent used in this process is not particularly limited as long as the organic semiconductor can be appropriately dissolved or dispersed in the solvent, but is preferably an organic solvent. Examples thereof include aliphatic hydrocarbons such as hexane, heptane, octane,

isooctane, nonane, decane, cyclohexane, decalin, and bicyclohexyl; alcohols such as methanol, ethanol, butanol, propanol, ethylene glycol, and glycerol; ketones such as acetone, methyl ethyl ketone, cyclopentanone, cyclohexanone, and isophorone; esters such as ethyl acetate, butyl acetate, methyl lactate, γ-butyrolactone, diethylene glycol monobutyl ether acetate, and dimethyl carbonate; ethers such as ethyl ether, methyl tertiary butyl ether, tetrahydrofuran, 1,4-dioxane, tetrahydropyran, 3,4-dihydro-2H-pyran, isochromane, ethylene glycol monomethyl ether, and diglyme; amines such as ammonia and ethanolamine; amides such as N,N-dimethylformamide, dimethylacetamide, and N-methyl-2-pyrrolidone; sulfones such as sulfolane; sulfoxides such as dimethylsulfoxide; thiols such as carbon disulfide and 1,8-octanedithiol; nitriles such as acetonitrile and acrylonitrile; fatty acids such as acetic acid and lactic acid; heterocyclic compounds such as furan, thiophene, pyrrole, and pyridine; aromatic hydrocarbons such as benzene, toluene, xylene, ethylbenzene, cumene, n-butylbenzene, sec-butylbenzene, tert-butylbenzene, styrene, mesitylene, 1,2,4-trimethylbenzene, p-cymene, cyclohexylbenzene, diethylbenzene, pentylbenzene, dipentylbenzene, dodecylbenzene, ethynylbenzene, tetralin, anisole, phenetole, butylphenyl ether, pentylphenyl ether, veratrole, 1,3-dimethoxybenzene, 1,2,4-trimethoxybenzene, 2-methoxytoluene, 2,5-dimethylanisole, o-chlorophenol, chlorobenzene, dichlorobenzene, trichlorobenzene, 1-chloronaphthalene, 1-bromonaphthalene, 1-methylnaphthalene, o-diiodobenzene, acetophenone, 2,3-benzofuran, 2,3-dihydrobenzofuran, 1,4-benzodioxane, phenyl acetate, methyl benzoate, cresol, aniline, and nitrobenzene; and halogen hydrocarbons such as dichloromethane, 1,2-dichloroethylene, trichloroethylene, tetrachloroethylene, chloroform, carbon tetrachloride, dichloroethane, trichloroethane, 1,3-dichloropropane, 1,1,1,2-tetrachloroethane, 1,1,1,3-tetrachloropropane, 1,2,2,3-tetrachloropropane, 1,1,2,3-tetrachloropropane, pentachloropropane, hexachloropropane, heptachloropropane, 1-bromopropane, 1,2-dibromopropane, 2,2-dibromopropane, 1,3-dibromopropane, 1,2,3-tribromopropane, 1,4-dibromobutane, 1,5-dibromopentane, 1,6-dibromohexane, 1,7-dibromoheptane, 1,8-dibromooctane, 1-iodopropane, 1,3-diiodopropane, 1,4-diiodobutane, 1,5-diiodopentane, 1,6-diiodohexane, 1,7-diiodoheptane, and 1,8-diiodooctane. Above all, preferable solvents include aromatic hydrocarbons such as toluene, xylene, mesitylene, 1,2,4-trimethylbenzene, tetralin, anisole, phenetole veratrole, 1,3-dimethoxybenzene, 1,2,4-trimethoxybenzene, 2-methoxytoluene, 2,5-dimethylanisole, chlorobenzene, dichlorobenzene, trichlorobenzene, and 1-chloronaphthalene, and halogen hydrocarbons such as chloroform, dichloromethane, 1,2-dibromopropane, 1,3-dibromopropane, 1,2,3-tribromopropane, 1,4-dibromobutane, 1,6-dibromohexane, 1,8-dibromooctane, 1,3-diiodopropane, 1,4-diiodobutane, 1,5-diiodopentane, 1,6-diiodohexane, 1,7-diiodoheptane, and 1,8-diiodooctane. Two or more kinds of these may be used as a mixture.

In the case of forming the photoelectric conversion layer from a mixture of an electron-donating organic material and an electron-accepting organic material, the electron-donating organic material and the electron-accepting organic material are added to a solvent at a desired ratio, a solution is obtained by dissolving the materials by a method such as heating, stirring, or ultrasonic irradiation, and the solution is applied to the cathode or the electron extraction layer. In the case of forming the photoelectric conversion layer by stacking an electron-donating organic material and an electron-accepting organic material, for example, a solution of an electron-donating organic material is applied to form a layer having the electron-donating organic material, and then a solution of an electron-accepting organic material is applied to form a layer. When the electron-donating organic material and the electron-accepting organic material are low-molecular compounds having a molecular weight of about 1000 or less, it is also possible to form a layer by vapor deposition.

For forming the photoelectric conversion layer, the same coating method as that for forming the electron extraction layer can be used. The formation method may be selected according to the photoelectric conversion layer characteristics to be obtained, such as film thickness control and orientation control. For example, in the case of spin coating, the electron-donating organic material and the electron-accepting organic material preferably have a concentration of 1 to 20 g/l (the weight of the electron-donating organic material and the electron-accepting organic material relative to the volume of a solution containing the electron-donating organic material, the electron-accepting organic material, and a solvent). At a concentration in this range, it is possible to obtain a homogeneous photoelectric conversion layer having a thickness of 5 to 200 nm. The formed photoelectric conversion layer may be subjected to annealing treatment under reduced pressure or in an inert atmosphere (in a nitrogen or argon atmosphere) in order to remove the solvent. The temperature for the annealing treatment is preferably 40°C to 300°C, more preferably 50°C to 200°C. The annealing treatment may be performed after the formation of the hole extraction layer anode.

Then, a hole extraction layer is formed on the photoelectric conversion layer by any of various film forming methods. A coating liquid that is a mixed solution of a desired hole transporting material (such as PEDOT:PSS) and the compound represented by the general formula (1) is prepared, the coating liquid is applied to the photoelectric conversion layer, and the solvent is removed using a vacuum thermostat, a hot plate or the like to form the hole extraction layer. As the coating method, the same coating method as that for forming the electron extraction layer can be used. Further, the hole extraction layer can also be formed by applying a mixed solution of a precursor such as a metal oxide and a compound represented by the general formula (1) to the photoelectric conversion layer, and then advancing the reaction using a vacuum thermostat, a hot plate or the like.

The anode can be formed on the hole extraction layer by forming a metal electrode made from Ag or the like by a vacuum deposition method or a sputtering method. In the case where the hole extraction layer is formed by vacuum

deposition, it is preferable to successively form the metal electrode while maintaining the vacuum.

In the above description, a method for producing a photovoltaic element by forming a cathode first on a substrate, and forming layers in order from the cathode side has been described. There is also a method for producing a photovoltaic element including forming an electrode (anode) on a substrate by a sputtering method or the like, and forming, on the electrode, a hole extraction layer containing a compound represented by the general formula (1), a photoelectric conversion layer, an electron extraction layer, and an electrode (cathode) in this order. In this case, the laminated structure of the photovoltaic element is reversed, and the hole extraction layer is formed under the photoelectric conversion layer, but the other configuration is the same as described above.

The photovoltaic element of the present invention can be applied to various photoelectric conversion devices based on a photoelectric conversion function, an optical rectification function and the like. For example, the photovoltaic element is useful for photovoltaic cells (such as solar cells), electronic elements (such as optical sensors, optical switches, and phototransistors), optical recording materials (such as optical memories), imaging devices and the like.

## EXAMPLES

Hereinafter, the present invention will be described more specifically by way of examples. The present invention is not limited to the following examples. Among the compounds used in examples and the like, those abbreviated are shown below.

Isc: Short circuit current density
Voc: Open circuit voltage
FF: Fill factor
η: Photoelectric conversion efficiency
ITO: Indium tin oxide
A-1: Compound represented by the following formula

[Chemical Formula 9]

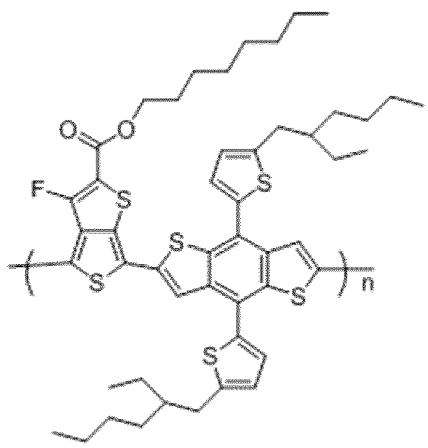

[70]PCBM: Phenyl C71 butyric acid methyl ester
CF: Chloroform

The photoelectric conversion efficiency in each of the examples and comparative examples was obtained by the following formulae.

$$\eta\ (\%) = \text{Isc}\ (\text{mA/cm}^2) \times \text{Voc}\ (\text{V}) \times \text{FF/intensity of light irradiation}\ (\text{mW/cm}^2) \times 100$$

$$FF = JVmax/(Isc\ (mA/cm^2) \times Voc\ (V))$$

JVmax ($mW/cm^2$) is the product of the current density and the applied voltage at the point where the product of the current density and the applied voltage is the maximum between an applied voltage of 0 V to the open circuit voltage.

Synthesis Example 1

Compound A-1 was synthesized by the method shown in Formula 1. Incidentally, Compound (1-i) was synthesized with reference to the method described in Journal of the American Chemical Society, 2009, vol. 131, pp. 7792-7799, and Compound (1-p) was synthesized with reference to the method described in Angewandte Chem International Edition, 2011, vol. 50, pp. 9697-9702.

[Chemical Formula 10]

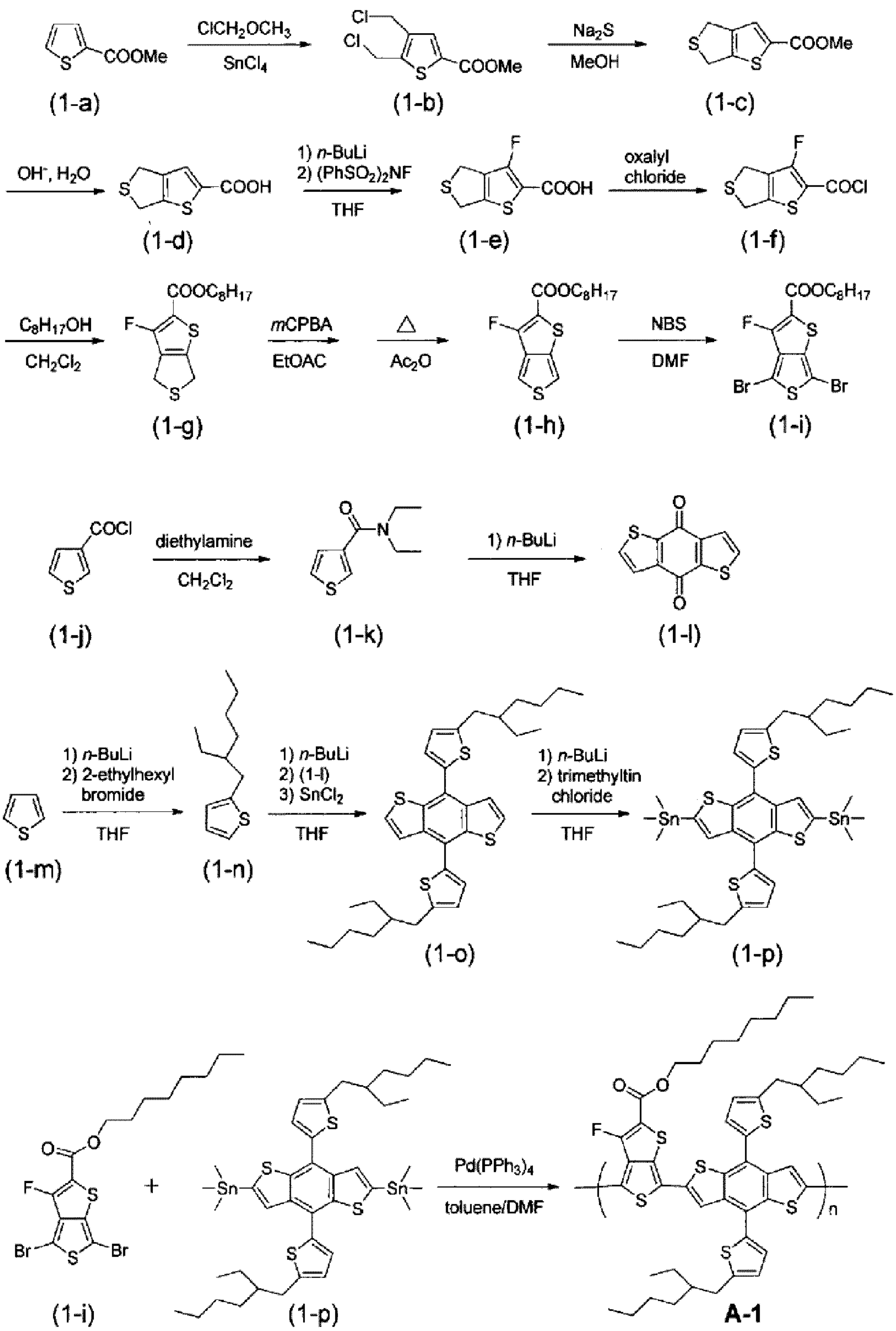


Formula 1

To 38 g (0.27 mol) of methyl-2-thiophene carboxylate (manufactured by Tokyo Chemical Industry Co., Ltd.) and 108 g (1.34 mol) of chloromethyl methyl ether (manufactured by Tokyo Chemical Industry Co., Ltd.) stirred at 0°C, 125 g (0.48 mol) of tin tetrachloride (manufactured by Wako Pure Chemical Industries, Ltd.) was added over 1 hour, and the mixture was stirred at room temperature for 8 hours. After completion of the stirring, 100 ml of water was added slowly at 0°C, and the mixture was extracted three times with chloroform. The organic layer was washed with saturated

saline, and the solvent was dried over anhydrous magnesium sulfate and then removed under reduced pressure. The obtained brown solid was recrystallized from methanol to give Compound (1-b) as a pale yellow solid (24.8 g, yield: 39%). The $^1$H-NMR measurement results of Compound (1-b) are shown below.

$^1$H-NMR (270 MHz, $CDCl_3$) : 7.71 (s, 1H), 4.79 (s, 1H), 4.59 (s, 1H), 3.88 (s, 3H) ppm.

In 1.2 L of methanol (manufactured by Sasaki Chemical Industry Co., Ltd.), 24.8 g (0.10 mmol) of Compound (1-b) was dissolved, and while the solution was stirred at 60°C, 100 ml of a solution of 8.9 g (0.11 mol) of sodium sulfide (manufactured by Sigma-Aldrich Japan) in methanol was added dropwise over 1 hour, and the mixture was further stirred at 60°C for 4 hours. After completion of the reaction, the solvent was removed under reduced pressure, 200 ml of chloroform and 200 ml of water were added, and an insoluble matter was filtered off. The organic layer was washed twice with water and once with saturated saline, and dried over anhydrous magnesium sulfate, and then the solvent was removed under reduced pressure. The crude purified product was purified by silica gel column chromatography (eluent: chloroform) to give Compound (1-c) as a white solid (9.8 g, yield: 48%). The $^1$H-NMR measurement results of Compound (1-c) are shown below.

$^1$H-NMR (270 MHz, $CDCl_3$) : 7.48 (s, 1H), 4.19 (t, J = 3.0 Hz, 2H), 4.05 (t, J = 3.0 Hz, 2H), 3.87 (s, 3H) ppm.

To 9.8 g (49 mmol) of Compound (1-c), 100 ml of water and then 30 ml of a 3 M aqueous sodium hydroxide solution were added, and the mixture was heated and stirred at 80°C for 4 hours. After completion of the reaction, 15 ml of concentrated hydrochloric acid was added at 0°C, and the precipitated solid was collected by filtration and washed several times with water. The obtained solid was dried to give Compound (1-d) as a white solid (8.9 g, yield: 98%).

$^1$H-NMR (270 MHz, DMSO-$d_6$) : 7.46 (s, 1H), 4.18 (t, J = 3.2 Hz, 2H), 4.01 (t, J = 3.2 Hz, 2H) ppm.

In 60 ml of dehydrated tetrahydrofuran (manufactured by Wako Pure Chemical Industries, Ltd.), 1.46 g (7.8 mmol) of Compound (1-d) was dissolved, and while the solution was stirred at -78°C, 10.7 ml (17.2 mmol) of a solution of n-butyllithium in hexane (1.6 M, manufactured by Wako Pure Chemical Industries, Ltd.) was added dropwise, and the mixture was stirred at -78°C for 1 hour. Then, 20 ml of a solution of 4.91 g (15.6 mmol) of N-fluorobenzenesulfonimide (manufactured by Tokyo Chemical Industry Co., Ltd.) in dried tetrahydrofuran was added dropwise at -78°C over 10 minutes, and the mixture was stirred at room temperature for 12 hours. After completion of the reaction, 50 ml of water was added slowly. To the aqueous layer, 3 M hydrochloric acid was added so that the aqueous layer would be acidic, and then the aqueous layer was extracted three times with chloroform. The organic layer was dried over anhydrous magnesium sulfate, and then the solvent was distilled off under reduced pressure. The byproduct was removed by silica gel column chromatography (eluent: ethyl acetate), and then the product was recrystallized from ethyl acetate to give Compound (1-e) as a pale yellow powder (980 mg, yield: 61%). The $^1$H-NMR measurement results of Compound (1-e) are shown below.

$^1$H-NMR (270 MHz, DMSO-$d_6$) : 13.31 (brs, 1H), 4.20 (t, J = 3.0 Hz, 2H), 4.03 (t, J = 3.0 Hz, 2H) ppm.

To 10 ml of a solution of 800 mg (3.9 mmol) of Compound (1-e) in dehydrated dichloromethane (manufactured by Wako Pure Chemical Industries, Ltd.), 1 ml of oxalyl chloride (manufactured by Tokyo Chemical Industry Co., Ltd.) and then one drop of dimethylformamide (manufactured by Wako Pure Chemical Industries, Ltd.) were added, and the mixture was stirred at room temperature for 3 hours. The solvent and excess oxalyl chloride were removed under reduced pressure to give Compound (1-f) as a yellow oil. Compound (1-f) was directly used in the next reaction.

To 15 ml of a solution of 1.3 g (10 mmol) of 1-octanol (manufactured by Wako Pure Chemical Industries, Ltd.) and 800 mg (8 mmol) of triethylamine (manufactured by Wako Pure Chemical Industries, Ltd.) in dichloromethane, 10 ml of a solution of the compound (1-f, crude purified product) in dichloromethane was added at room temperature, and the mixture was stirred at room temperature for 6 hours. The reaction solution was washed twice with 1 M hydrochloric acid, once with water, and once with saturated saline, and dried over anhydrous magnesium sulfate, and the solvent was distilled off under reduced pressure. The product was purified by silica gel column chromatography (eluent: chloroform) to give Compound (1-g) as a pale yellow solid (1.12 g, yield: 90%). The $^1$H-NMR measurement results of Compound (1-g) are shown below.

$^1$H-NMR (270 MHz, $CDCl_3$) : 4.27 (t, J = 6.7 Hz, 2H), 4.16 (t, J = 3.0 Hz, 2H), 4.01 (t, J = 3.0 Hz, 2H), 1.72 (m, 2H), 1.5-1.3 (m, 12H), 0.88 (t, J = 7.0 Hz, 3H) ppm.

To 40 ml of a solution of 1.1 g (3.5 mmol) of Compound (1-g) in ethyl acetate, 10 ml of a solution of 630 mg (3.6 mmol) of m-chlorobenzoic acid (manufactured by NACALAI TESQUE, INC.) in ethyl acetate was added dropwise at 0°C, and the mixture was stirred at room temperature for 5 hours. The solvent was removed under reduced pressure, then 30 ml of acetic anhydride was added, and the mixture was heated under reflux for 3 hours. The solvent was removed under reduced pressure again, and then the product was purified by silica gel column chromatography (eluent: dichloromethane : hexane = 1 : 1) to give Compound (1-h) as a pale yellow oil (1.03 g, yield: 94%). The $^1$H-NMR measurement results of Compound (1-h) are shown below.

$^1$H-NMR (270 MHz, $CDCl_3$) : 7.65 (d, J = 2.7 Hz, 1H), 7.28 (dd, J = 2.7 Hz and 5.4 Hz, 1H), 4.31 (t, J = 6.8 Hz, 2H), 1.75 (m, 2H), 1.42-1.29 (m, 12H), 0.89 (t, J = 6.8 Hz, 3H) ppm.

To 20 ml of a solution of 1.0 g (3.2 mmol) of Compound (1-h) in dimethylformamide, 1.25 g (7.0 mmol) of N-bromosuccinimide (manufactured by Wako Pure Chemical Industries, Ltd.) was added at room temperature, and the

mixture was stirred at room temperature for 3 hours. After completion of the reaction, 10 ml of a 5% aqueous sodium thiosulfate solution was added, and the mixture was stirred for 5 minutes. Ethyl acetate (80 ml) was added, and the organic layer was washed five times with water and once with saturated saline, and dried over anhydrous magnesium sulfate. Then, the solvent was distilled off under reduced pressure. The product was purified by silica gel column chromatography (eluent: chloroform : hexane = 1 : 3) to give Compound (1-i) as a pale yellow solid (1.2 g, yield: 79%). The $^1$H-NMR measurement results of Compound (1-i) are shown below.
$^1$H-NMR (270 MHz, $CDCl_3$) : 4.32 (t, J = 6.5 Hz, 2H), 1.75 (m, 2H), 1.42-1.29 (m, 12H), 0.89 (t, J = 6.8 Hz, 3H) ppm.

To 300 ml of a solution of 110 g (1.5 mol) of diethylamine (manufactured by Wako Pure Chemical Industries, Ltd.) in dichloromethane, 100 g (0.68 mol) of 3-thiophenecarbonyl chloride (manufactured by Wako Pure Chemical Industries, Ltd.) was added at 0°C over 1 hour, and the mixture was stirred at room temperature for 3 hours. After completion of the stirring, 200 ml of water was added, and the organic layer was washed three times with water and once with saturated saline. The organic layer was dried over anhydrous magnesium sulfate, and then the solvent was distilled off under reduced pressure. The residue was distilled under reduced pressure to give Compound (1-k) as a pale orange liquid (102 g, yield: 82%). The $^1$H-NMR measurement results of Compound (1-k) are shown below.
$^1$H-NMR (270 MHz, $CDCl_3$) : 7.47 (dd, J = 3.2 Hz and 1.0 Hz, 1H), 7.32 (dd, J = 5.0 Hz and 3.2 Hz, 1H), 7.19 (dd, J = 5.0 Hz and 1.0 Hz, 1H), 3.43 (brs, 4H), 1.20 (t, J = 6.5 Hz, 6H) ppm.

To 400 ml of a solution of 73.3 g (0.40 mol) of Compound (1-k) in dehydrated tetrahydrofuran (manufactured by Wako Pure Chemical Industries, Ltd.), 250 ml (0.40 mol) of a solution of n-butyllithium in hexane (1.6 M, manufactured by Wako Pure Chemical Industries, Ltd.) was added dropwise at 0°C over 30 minutes. After completion of the dropwise addition, the mixture was stirred at room temperature for 4 hours. After completion of the stirring, 100 ml of water was added slowly and the mixture was stirred for a while. Then, the reaction mixture was poured into 800 ml of water. The precipitated solid was collected by filtration and washed with water, methanol, and then hexane in this order to give Compound (1-1) as a yellow solid (23.8 g, yield: 27%). The $^1$H-NMR measurement results of Compound (1-1) are shown below.
$^1$H-NMR (270 MHz, $CDCl_3$) : 7.69 (d, J = 4.9 Hz, 2H), 7.64 (d, J = 4.9 Hz, 2H) ppm.

To 400 ml of a solution of 42 g (0.50 mol) of thiophene in dehydrated tetrahydrofuran (manufactured by Wako Pure Chemical Industries, Ltd.), 250 ml (0.40 mol) of a solution of n-butyllithium in hexane (1.6 M, manufactured by Wako Pure Chemical Industries, Ltd.) was added dropwise at -78°C over 30 minutes. The reaction mixture was stirred at -78°C for 1 hour, and then 76.4 g (0.40 mol) of 2-ethylhexyl bromide (manufactured by Wako Pure Chemical Industries, Ltd.) was added dropwise at -78°C over 15 minutes. The reaction solution was stirred at room temperature for 30 minutes, and then heated and stirred at 60°C for 6 hours. After completion of the stirring, the reaction solution was cooled to room temperature, and 200 ml of water and 200 ml of diethyl ether were added. The organic layer was washed twice with water and with saturated saline, and then dried over anhydrous magnesium sulfate, and the solvent was removed under reduced pressure. The residue was distilled under reduced pressure to give Compound (1-n) as a colorless liquid (28.3 g, 36%). The $^1$H-NMR measurement results of Compound (1-n) are shown below.
$^1$H-NMR (270 MHz, $CDCl_3$) : 7.11 (d, 4.9 Hz, 1H), 6.92 (dd, 4.9 Hz and 3.2 Hz, 1H), 6.76 (d, J = 3.2 Hz, 1H), 2.76 (d, J = 6.8 Hz, 2H), 1.62 (m, 1H), 1.4-1.3 (m, 8H), 0.88 (m, 6H) ppm.

To 400 ml of a solution of 17.5 g (89 mmol) of Compound (1-n) in dehydrated tetrahydrofuran (manufactured by Wako Pure Chemical Industries, Ltd.), 57 ml (89 mmol) of a solution of n-butyllithium in hexane (1.6 M, manufactured by Wako Pure Chemical Industries, Ltd.) was added dropwise at 0°C over 30 minutes. The reaction solution was stirred at 50°C for 1 hour, then 4.9 g (22 mmol) of Compound (1-1) was added at 50°C, and the mixture was directly stirred for 1 hour. After completion of the stirring, the reaction solution was cooled to 0°C, a solution of 39.2 g (175 mmol) of tin chloride dihydrate (manufactured by Wako Pure Chemical Industries, Ltd.) dissolved in 80 ml of 10% hydrochloric acid was added, and the mixture was stirred at room temperature for 1 hour. After completion of the stirring, 200 ml of water and 200 ml of diethyl ether were added, and the organic layer was washed twice with water and then with saturated saline. The organic layer was dried over anhydrous magnesium sulfate, and then the solvent was distilled off under reduced pressure. The product was purified by silica gel column chromatography (eluent: hexane) to give Compound (1-o) as a yellow oil (7.7 g, yield: 59%). The $^1$H-NMR measurement results of Compound (1-o) are shown below.
$^1$H-NMR (270 MHz, $CDCl_3$) : 7.63 (d, J = 5.7 Hz, 1H), 7.45 (d, J = 5.7 Hz, 1H), 7.29 (d, J = 3.6 Hz, 1H), 6.88 (d, J = 3.6 Hz, 1H), 2.86 (d, J = 7.0 Hz, 2H), 1.70-1.61 (m, 1H), 1.56-1.41 (m, 8H), 0.97-0.89 (m, 6H) ppm.

To 25 ml of a solution of 870 mg (1.5 mmol) of Compound (1-o) in dehydrated tetrahydrofuran (manufactured by Wako Pure Chemical Industries, Ltd.), 2.0 ml (3.3 mmol) of a solution of n-butyllithium in hexane (1.6 M, manufactured by Wako Pure Chemical Industries, Ltd.) was added at -78°C using a syringe, and the mixture was stirred at -78°C for 30 minutes and at room temperature for 30 minutes. The reaction mixture was cooled to -78°C, then 800 mg (4.0 mmol) of trimethyltin chloride (manufactured by Wako Pure Chemical Industries, Ltd.) was added at once at -78°C, and the mixture was stirred at room temperature for 4 hours. After completion of the stirring, 50 ml of diethyl ether and 50 ml of water were added, the mixture was stirred at room temperature for 5 minutes, and then the organic layer was washed twice with water and then with saturated saline. The solvent was dried over anhydrous sodium sulfate, and then distilled

off under reduced pressure. The obtained orange oil was recrystallized from ethanol to give Compound (1-p) as a pale yellow solid (710 mg, yield: 52%). The $^1$H-NMR measurement results of Compound (1-p) are shown below.
$^1$H-NMR (270 MHz, $CDCl_3$) : 7.68 (s, 2H), 7.31 (d, J = 3.2 Hz, 2H), 6.90 (d, J = 3.2 Hz, 2H), 2.87 (d, J = 6.2 Hz, 4H), 1.69 (m, 2H), 1.40-1.30 (m, 16H), 1.0-0.9 (m, 12H), 0.39 (s, 18H) ppm.

In 4 ml of toluene (manufactured by Wako Pure Chemical Industries, Ltd.) and 1 ml of dimethylformamide (manufactured by Wako Pure Chemical Industries, Ltd.), 71 mg (0.15 mmol) of Compound (1-i) and 136 mg (0.15 mmol) of Compound (1-p) were dissolved. To the solution, 5 mg of tetrakis triphenylphosphine palladium (manufactured by Tokyo Chemical Industry Co., Ltd.) was added, and the mixture was stirred at 100°C for 15 hours in a nitrogen atmosphere. Then, 15 mg of bromobenzene (manufactured by Tokyo Chemical Industry Co., Ltd.) was added, and the mixture was stirred at 100°C for 1 hour. Then, 40 mg of tributyl(2-thienyl)tin (manufactured by Tokyo Chemical Industry Co., Ltd.) was added, and the mixture was further stirred at 100°C for 1 hour. After completion of the stirring, the reaction mixture was cooled to room temperature, and poured into 100 ml of methanol. The precipitated solid was collected by filtration, and washed with methanol, water, and acetone in this order. Then, using a Soxhlet extractor, the solid was washed with acetone and hexane in this order. Then, the obtained solid was dissolved in chloroform, passed through Celite (manufactured by NACALAI TESQUE, INC.), and then passed through a silica gel column (free liquid: chloroform), and then the solvent was distilled off under reduced pressure. The obtained solid was dissolved in chloroform again, and then reprecipitated in methanol to give Compound A-1 (85 mg). Compound A-1 had a weight average molecular weight of 25,000 and a number average molecular weight of 16,000.

[Example 1]

To a sample bottle containing 10 mg of zinc acetate dihydrate (manufactured by Wako Pure Chemical Industries, Ltd.), 5 μL of water and 0.5 mL of an ethanol solvent (manufactured by Wako Pure Chemical Industries, Ltd.) were added and thermally dissolved to give Solution A. To Solution A, 1% by volume of 3-aminopropyltriethoxysilane (manufactured by Sigma-Aldrich Japan) was added to give Solution B. To a sample bottle containing 0.9 mg of A-1 and 1.1 mg of [70]PCBM (manufactured by Solenne BV), 0.2 mL of a chloroform solvent mixed with 2% by volume of 3,4,5-trimethoxytoluene (manufactured by Tokyo Chemical Industry Co., Ltd.) was added, and the contents were subjected to ultrasonic irradiation for 30 minutes in an ultrasonic cleaner (US-2 manufactured by Iuchi Seieido Co., Ltd., output: 120 W) to give Solution C. An aqueous PEDOT:PSS solution (CLEVIOS P VP AI 4083), water, and 2-propanol (manufactured by Wako Pure Chemical Industries, Ltd.) were mixed at a volume ratio of 30 : 50 : 20 to give Solution D. Polyoxyethylene (4) lauryl ether (manufactured by Sigma-Aldrich Japan) was added to Solution D so that the solution would have a concentration of 0.2% by weight to prepare a hole extraction layer coating liquid.

A glass substrate, on which 125 nm of an ITO transparent conductive layer serving as a cathode was deposited by a sputtering method, was cut into 38 mm × 46 mm, and the ITO was patterned into a rectangular shape of 38 mm × 13 mm by photolithography. As a result of measuring the light transmittance of the obtained substrate with Hitachi spectrophotometer U-3010, the light transmittance was 85% or more in the whole wavelength region of 400 nm to 900 nm. The substrate was subjected to ultrasonic cleaning with an alkaline cleaning liquid ("Semico Clean" EL56 manufactured by Furuuchi Chemical Corporation) for 10 minutes, and then washed with ultrapure water. The substrate was subjected to UV/ozone treatment for 30 minutes, and then Solution A was dropped on the glass substrate. After spin coating, the substrate was heated on a hot plate at 150°C for 30 minutes to form an electron extraction layer having a thickness of about 30 nm. Solution C was dropped on the electron extraction layer and applied by spin coating, and then dried by heating on a hot plate at 80°C for 5 minutes to form a photoelectric conversion layer having a film thickness of 130 nm. The hole extraction layer coating liquid prepared as described above was dropped on the photoelectric conversion layer and applied by spin coating, and then heated on a hot plate at 80°C for 5 minutes to form a hole transporting layer. It was confirmed by visual observation that the film of the hole extraction layer coating liquid was successfully formed without the coating liquid being repelled on the photoelectric conversion layer. Then, the substrate and an anode mask were placed in a vacuum deposition apparatus, and the apparatus was evacuated until the degree of vacuum in the apparatus reached $1 \times 10^{-3}$ Pa or less. A silver layer having a thickness of 100 nm and serving as an anode was vapor-deposited by a resistance heating method. An extraction electrode was taken out of the upper and lower electrodes of the produced element, and a photovoltaic element in which the area of a portion where the strip-shaped ITO layer and the silver layer overlap was 5 mm × 5 mm was produced.

The upper and lower electrodes of the photovoltaic element produced as described above were connected to a picoammeter/voltage source 4140B manufactured by Hewlett-Packard Company. White light (AM 1.5; 100 mW/$cm^2$) was continuously applied from the ITO layer side in the atmosphere, and the current values at various applied voltages of -1 V to +2 V were measured. As a result of calculating the photoelectric conversion efficiency (η) from the obtained current values, the photoelectric conversion efficiency was 7.80%.

[Example 2]

A photovoltaic element was produced in exactly the same manner as in Example 1 except that, in the production of the hole extraction layer coating liquid, 0.2% by weight of polyoxyethylene (3) lauryl ether (EMULGEN 103 manufactured by Kao Corporation) was added to a solution obtained by mixing the aqueous PEDOT:PSS solution with 2-propanol at a volume ratio of 20 : 80 to prepare a hole extraction layer coating liquid, and the measurement was performed.

[Example 3]

A photovoltaic element was produced in exactly the same manner as in Example 1 except that a hole extraction layer coating liquid was prepared using polyoxyethylene (5) lauryl ether (EMULGEN 106 manufactured by Kao Corporation) in place of polyoxyethylene (4) lauryl ether, and the measurement was performed.

[Example 4]

A photovoltaic element was produced in exactly the same manner as in Example 1 except that a hole extraction layer coating liquid was prepared using polyoxyethylene (6) lauryl ether (EMULGEN 108 manufactured by Kao Corporation) in place of polyoxyethylene (4) lauryl ether, and the measurement was performed.

[Example 5]

A photovoltaic element was produced in exactly the same manner as in Example 1 except that a hole extraction layer coating liquid was prepared using polyoxyethylene (9) lauryl ether (EMULGEN 109P manufactured by Kao Corporation) in place of polyoxyethylene (4) lauryl ether, and the measurement was performed.

[Example 6]

A photovoltaic element was produced in exactly the same manner as in Example 1 except that a hole extraction layer coating liquid was prepared using polyoxyethylene (5) tridecyl ether (Newkalgen D-1205 manufactured by TAKEMOTO OIL & FAT Co., Ltd.) in place of polyoxyethylene (4) lauryl ether, and the measurement was performed.

[Example 7]

A photovoltaic element was produced in exactly the same manner as in Example 1 except that a hole extraction layer coating liquid was prepared using polyoxyethylene (8) tridecyl ether (Newkalgen D-1208 manufactured by TAKEMOTO OIL & FAT Co., Ltd.) in place of polyoxyethylene (4) lauryl ether, and the measurement was performed.

[Example 8]

A photovoltaic element was produced in exactly the same manner as in Example 1 except that a hole extraction layer coating liquid was prepared using polyoxyethylene (7) oleyl ether (manufactured by Tokyo Chemical Industry Co., Ltd.) in place of polyoxyethylene (4) lauryl ether, and the measurement was performed.

[Example 9]

A photovoltaic element was produced in exactly the same manner as in Example 1 except that a hole extraction layer coating liquid was prepared using polyoxyethylene (10) oleyl ether (manufactured by Tokyo Chemical Industry Co., Ltd.) in place of polyoxyethylene (4) lauryl ether, and the measurement was performed.

[Example 10]

A photovoltaic element was produced in exactly the same manner as in Example 1 except that a hole extraction layer coating liquid was prepared using polyoxyethylene (13) oleyl ether (manufactured by Tokyo Chemical Industry Co., Ltd.) in place of polyoxyethylene (4) lauryl ether, and the measurement was performed.

[Comparative Example 1]

An attempt was made to produce a photovoltaic element in exactly the same manner as in Example 1 except

that a hole extraction layer coating liquid was prepared without adding polyoxyethylene (4) lauryl ether. The hole extraction layer coating liquid, however, was repelled on the photoelectric conversion layer, and no hole extraction layer was formed.

[Comparative Example 2]

A photovoltaic element was produced in exactly the same manner as in Example 1 except that a hole extraction layer coating liquid was prepared using an acetylene glycol surfactant OLFINE EXP.4200 (manufactured by Nissin Chemical Industry Co., Ltd.) in place of polyoxyethylene (4) lauryl ether, and the measurement was performed.

[Comparative Example 3]

A photovoltaic element was produced in exactly the same manner as in Example 1 except that a hole extraction layer coating liquid was prepared using polyoxyethylene (10) octylphenyl ether (Triton X-100 (manufactured by MP Biomedicals, LLC.)) in place of polyoxyethylene (4) lauryl ether, and the measurement was performed.

[Comparative Example 4]

An attempt was made to produce a photovoltaic element in exactly the same manner as in Example 1 except that a hole extraction layer coating liquid was prepared using polyoxyethylene (10) lauryl ether (Pionine D-1110 manufactured by TAKEMOTO OIL & FAT Co., Ltd.) in place of polyoxyethylene (4) lauryl ether. The hole extraction layer coating liquid, however, was repelled on the photoelectric conversion layer, and no hole extraction layer was formed.

[Comparative Example 5]

An attempt was made to produce a photovoltaic element in exactly the same manner as in Example 1 except that a hole extraction layer coating liquid was prepared using polyoxyethylene (23) lauryl ether (manufactured by Wako Pure Chemical Industries, Ltd.) in place of polyoxyethylene (4) lauryl ether. The hole extraction layer coating liquid, however, was repelled on the photoelectric conversion layer, and no hole extraction layer was formed.

[Comparative Example 6]

An attempt was made to produce a photovoltaic element in exactly the same manner as in Example 1 except that a hole extraction layer coating liquid was prepared using polyoxyethylene (2) cetyl ether (manufactured by Sigma-Aldrich Japan) in place of polyoxyethylene (4) lauryl ether. The hole extraction layer coating liquid, however, was repelled on the photoelectric conversion layer, and no hole extraction layer was formed.

[Comparative Example 7]

An attempt was made to produce a photovoltaic element in exactly the same manner as in Example 1 except that a hole extraction layer coating liquid was prepared using polyoxyethylene (5) cetyl ether (Pionine D-1305-Z manufactured by TAKEMOTO OIL & FAT Co., Ltd.) in place of polyoxyethylene (4) lauryl ether. The hole extraction layer coating liquid, however, was repelled on the photoelectric conversion layer, and no hole extraction layer was formed.

[Comparative Example 8]

An attempt was made to produce a photovoltaic element in exactly the same manner as in Example 1 except that a hole extraction layer coating liquid was prepared using polyoxyethylene (8) cetyl ether (NONION P-208 manufactured by NOF CORPORATION) in place of polyoxyethylene (4) lauryl ether. The hole extraction layer coating liquid, however, was repelled on the photoelectric conversion layer, and no hole extraction layer was formed.

[Comparative Example 9]

An attempt was made to produce a photovoltaic element in exactly the same manner as in Example 1 except that a hole extraction layer coating liquid was prepared using polyoxyethylene (10) cetyl ether (manufactured by Sigma-Aldrich Japan) in place of polyoxyethylene (4) lauryl ether. The hole extraction layer coating liquid, however, was repelled on the photoelectric conversion layer, and no hole extraction layer was formed.

[Comparative Example 10]

An attempt was made to produce a photovoltaic element in exactly the same manner as in Example 1 except that a hole extraction layer coating liquid was prepared using polyoxyethylene (20) cetyl ether (manufactured by Wako Pure Chemical Industries, Ltd.) in place of polyoxyethylene (4) lauryl ether. The hole extraction layer coating liquid, however, was repelled on the photoelectric conversion layer, and no hole extraction layer was formed.

[Comparative Example 11]

An attempt was made to produce a photovoltaic element in exactly the same manner as in Example 1 except that a hole extraction layer coating liquid was prepared using polyoxyethylene (4) stearyl ether (manufactured by FUJIFILM Wako Chemical Corporation) in place of polyoxyethylene (4) lauryl ether. The hole extraction layer coating liquid, however, was repelled on the photoelectric conversion layer, and no hole extraction layer was formed.

[Comparative Example 12]

An attempt was made to produce a photovoltaic element in exactly the same manner as in Example 1 except that a hole extraction layer coating liquid was prepared using polyoxyethylene (10) stearyl ether (manufactured by Sigma-Aldrich Japan) in place of polyoxyethylene (4) lauryl ether. The hole extraction layer coating liquid, however, was repelled on the photoelectric conversion layer, and no hole extraction layer was formed.

[Comparative Example 13]

An attempt was made to produce a photovoltaic element in exactly the same manner as in Example 1 except that a hole extraction layer coating liquid was prepared using polyoxyethylene (20) stearyl ether (manufactured by FUJIFILM Wako Chemical Corporation) in place of polyoxyethylene (4) lauryl ether. The hole extraction layer coating liquid, however, was repelled on the photoelectric conversion layer, and no hole extraction layer was formed.

The results including the kind of compounds such as surfactants contained in the hole extraction layers of the photovoltaic elements produced in the examples and comparative examples, film forming properties thereof, and photoelectric conversion efficiency of the produced photovoltaic elements are summarized in Tables 1 and 2. As for the film forming properties of the hole extraction layer, the case where the hole extraction layer was successfully formed without the hole extraction layer coating liquid being repelled on the photoelectric conversion layer by visual observation was evaluated as "good", and the case where the hole extraction layer was not formed due to the hole extraction layer coating liquid being repelled on the photoelectric conversion layer by visual observation was evaluated as "poor". From the comparison between Examples 1 to 10 and Comparative Examples 1 to 13, it is understood that the present invention provides a photovoltaic element that is improved in the film forming properties of the hole extraction layer and is excellent in photoelectric conversion efficiency.

[Table 1]

| | Surfactant contained in hole extraction layer | | | | Film forming properties of hole extraction layer | Evaluation results of photovoltaic element | | | |
|---|---|---|---|---|---|---|---|---|---|
| | Name of chemical | Structural formula | Number of carbon atoms in $R^1$ or $R^2$ | n or m | | Isc (mA/cm$^2$) | Voc (V) | FF | η (%) |
| Example 1 | Polyoxyethylene (4) lauryl ether | General formula (1) | 12 | 4 | Good | 15.9 | 0.79 | 0.621 | 7.80 |
| Example 2 | Polyoxyethylene (3) lauryl ether | General formula (1) | 12 | 3 | Good | 15.9 | 0.80 | 0.621 | 7.91 |
| Example 3 | Polyoxyethylene (5) lauryl ether | General formula (1) | 12 | 5 | Good | 16.3 | 0.79 | 0.634 | 8.14 |

(continued)

| | Surfactant contained in hole extraction layer | | | | Film forming properties of hole extraction layer | Evaluation results of photovoltaic element | | | |
|---|---|---|---|---|---|---|---|---|---|
| | Name of chemical | Structural formula | Number of carbon atoms in $R^1$ or $R^2$ | n or m | | Isc ($mA/cm^2$) | Voc (V) | FF | η (%) |
| Example 4 | Polyoxyethylene (6) lauryl ether | General formula (1) | 12 | 6 | Good | 16.3 | 0.79 | 0.639 | 8.24 |
| Example 5 | Polyoxyethylene (9) lauryl ether | General formula (1) | 12 | 9 | Good | 16.1 | 0.79 | 0.622 | 7.90 |
| Example 6 | Polyoxyethylene (5) tridecyl ether | General formula (1) | 13 | 5 | Good | 15.6 | 0.78 | 0.626 | 7.60 |
| Example 7 | Polyoxyethylene (8) tridecyl ether | General formula (1) | 13 | 8 | Good | 15.6 | 0.78 | 0.627 | 7.63 |
| Example 8 | Polyoxyethylene (7) oleyl ether | General formula (2) | 18 | 7 | Good | 15.5 | 0.80 | 0.578 | 7.18 |
| Example 9 | Polyoxyethylene (10) oleyl ether | General formula (2) | 18 | 10 | Good | 15.4 | 0.80 | 0.599 | 7.38 |
| Example 10 | Polyoxyethylene (13) oleyl ether | General formula (2) | 18 | 13 | Good | 16.1 | 0.79 | 0.612 | 7.79 |

[Table 2]

| | Surfactant contained in hole extraction layer | | | | Film forming properties of hole extraction layer | Evaluation results of photovoltaic element | | | |
|---|---|---|---|---|---|---|---|---|---|
| | Name of chemical | Kind of end group | Number of carbon atoms in end group | Repeating number of oxyethylene units | | Isc ($mA/cm^2$) | Voc (V) | FF | η (%) |
| Comparative Example 1 | Not added | - | - | - | Poor | - | - | - | - |
| Comparative Example 2 | OLFINE EXP.4200 | - | - | - | Good | 16.0 | 0.75 | 0.505 | 6.04 |
| Comparative Example 3 | Triton X-100 | - | - | - | Good | 15.4 | 0.80 | 0.528 | 6.49 |
| Comparative Example 4 | Polyoxyethylene (10) lauryl ether | Alkyl group | 12 | 10 | Poor | - | - | - | - |
| Comparative Example 5 | Polyoxyethylene (23) lauryl ether | Alkyl group | 12 | 23 | Poor | - | - | - | - |
| Comparative Example 6 | Polyoxyethylene (2) cetyl ether | Alkyl group | 16 | 2 | Poor | - | - | - | - |
| Comparative Example 7 | Polyoxyethylene (5) cetyl ether | Alkyl group | 16 | 5 | Poor | - | - | - | - |
| Comparative Example 8 | Polyoxyethylene (8) cetyl ether | Alkyl group | 16 | 8 | Poor | - | - | - | - |
| Comparative Example 9 | Polyoxyethylene (10) cetyl ether | Alkyl group | 16 | 10 | Poor | - | - | - | - |
| Comparative Example 10 | Polyoxyethylene (20) cetyl ether | Alkyl group | 16 | 20 | Poor | - | - | - | - |
| Comparative Example 11 | Polyoxyethylene (4) stearyl ether | Alkyl group | 18 | 4 | Poor | - | - | - | - |
| Comparative Example 12 | Polyoxyethylene (10) stearyl ether | Alkyl group | 18 | 10 | Poor | - | - | - | - |
| Comparative Example 13 | Polyoxyethylene (20) stearyl ether | Alkyl group | 18 | 20 | Poor | - | - | - | - |

DESCRIPTION OF REFERENCE SIGNS

1: Substrate
2: Cathode
3: Photoelectric conversion layer
4: Hole extraction layer
5: Anode

## Claims

1. A photovoltaic element comprising at least a cathode, a photoelectric conversion layer, a hole extraction layer, and an anode in this order, the hole extraction layer containing a hole transporting material and a compound represented by the following general formula (1) or (2):

[Chemical Formula 1]

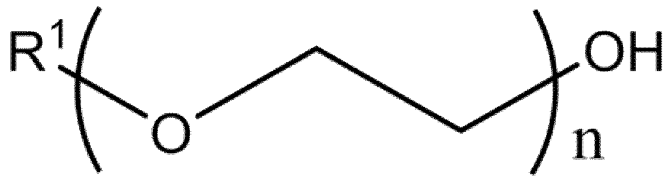

(1)

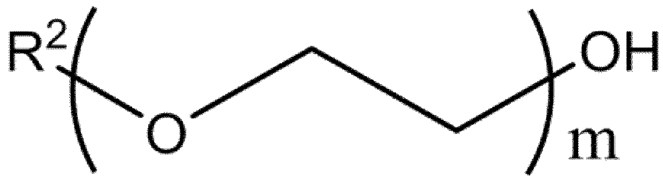

(2)

wherein, in the formula (1), $R^1$ represents an alkyl group having 8 to 14 carbon atoms or an alkanoyl group having 8 to 14 carbon atoms, and n represents a natural number of 1 to 9; and in the formula (2), $R^2$ represents an alkenyl group, and m represents a natural number.

2. The photovoltaic element according to claim 1, comprising the compound represented by the general formula (1) wherein $R^1$ is an alkyl group having 10 to 13 carbon atoms or an alkanoyl group having 10 to 13 carbon atoms.

3. The photovoltaic element according to claim 1 or 2, comprising the compound represented by the general formula (1) wherein n is a natural number of 3 to 6.

4. The photovoltaic element according to claim 1, comprising the compound represented by the general formula (2) wherein $R^2$ is an oleyl group, and m is a natural number of 5 to 20.

5. The photovoltaic element according to claim 1 or 4, comprising the compound represented by the general formula (2) wherein m is a natural number of 7 to 13.

6. The photovoltaic element according to any one of claims 1 to 5, wherein the hole transporting material contains a conductive polymer.

7. The photovoltaic element according to any one of claims 1 to 6, comprising, as the conductive polymer, polyethylene dioxythiophene to which polystyrene sulfonate is added.

8. The photovoltaic element according to any one of claims 1 to 7, wherein the photoelectric conversion layer contains an electron-donating organic semiconductor and a fullerene or a fullerene derivative.

[Fig 1]

[Fig 1]

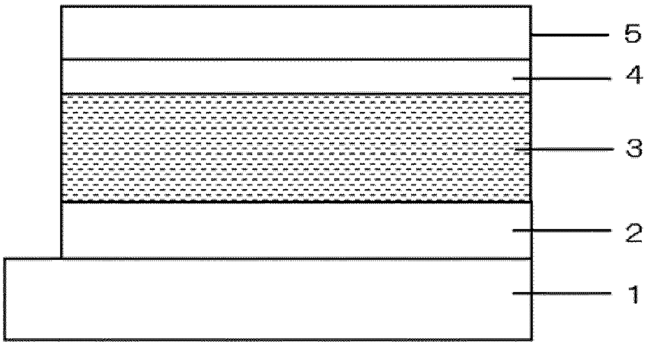

## INTERNATIONAL SEARCH REPORT

International application No.
PCT/JP2017/009950

A. CLASSIFICATION OF SUBJECT MATTER
*H01L51/46*(2006.01)i, *C08K5/06*(2006.01)i, *C08L25/02*(2006.01)i, *C08L65/00*(2006.01)i, *C08L71/02*(2006.01)i

According to International Patent Classification (IPC) or to both national classification and IPC

B. FIELDS SEARCHED

Minimum documentation searched (classification system followed by classification symbols)
H01L51/00-51/56, C08K5/06, C08L25/02, C08L65/00, C08L71/02

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | WO 2012/153845 A1 (Konica Minolta, Inc.), 15 November 2012 (15.11.2012), paragraphs [0122], [0138], [0151] & JP 5920341 B2 | 1-8 |
| Y | JP 2009-238593 A (Casio Computer Co., Ltd.), 15 October 2009 (15.10.2009), claims 1, 2; paragraphs [0024] to [0028], [0034] to [0041] (Family: none) | 1-8 |
| Y | JP 2015-124316 A (Tosoh Corp.), 06 July 2015 (06.07.2015), paragraph [0078] (Family: none) | 1-8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 22 March 2017 (22.03.17) | 18 April 2017 (18.04.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2017/009950

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2015-165491 A (Mitsubishi Chemical Corp.), 17 September 2015 (17.09.2015), paragraphs [0028], [0205] & JP 2015-165015 A | 4-5 |
| Y | JP 2015-101544 A (Kao Corp.), 04 June 2015 (04.06.2015), paragraph [0049] (Family: none) | 4-5 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2014027174 A
- JP 05829734 B


### Non-patent literature cited in the description


- *Advanced Materials,* 2010, vol. 22, E135-E138
- *Journal of the American Chemistry,* 2010, vol. 132, 7595-7597
- *Macromolecules,* 2012, vol. 45, 6923-6929
- *Advanced Materials,* 2011, vol. 23, 3315-3319
- *Advanced Materials,* 2006, vol. 18, 572-576
- *Journal of the American Chemical Society,* 2009, vol. 131, 7792-7799
- *Angewandte Chem International Edition,* 2011, vol. 50, 9697-9702